# FASCICULE DE BREVET EUROPEEN

(11) **EP 1 147 518 B1**
(45) Date de publication et mention de la délivrance du brevet: **14.08.2002**
(21) Numéro de dépôt: 99973160.7
(22) Date de dépôt: 01.12.1999
(51) Int. Cl.: G11C 7/00, G11C 8/00

(54) **SYSTEME ELECTRIQUE ET/OU ELECTRONIQUE INTEGRE A DES MOYENS D'ISOLATION D'UN MODULE FONCTIONNEL, DISPOSITIF ET PROCEDE D'ISOLATION ET UTILISATION CORRESPONDANTS**
ELEKTRONISCHE UND/ODER ELEKTRISCHE INTEGRIERTE SCHALTUNG MIT ISOLATIONSMITTELN ENES FUNKTIONELLEN MODULS , ISOLATIONSANORDNUNG UND -VERFAHREN SOWIE IHRE VERWENDUNG
INTEGRATED ELECTRIC AND/OR ELECTRONIC SYSTEM WITH MEANS FOR INSULATING A FUNCTIONAL MODULE, CORRESPONDING DEVICE AND METHOD FOR INSULATION AND USE

(30) Priorité: 01.12.1998 FR 9815103
(43) Date de publication de la demande: 24.10.2001
(73) Titulaire: Etat Français représenté par le Délégué Général pour l' Armement, 00457 Armées (FR)
(72) Inventeur: ANDRIEU, Claude, F-35200 Rennes (FR); HOUDEQUIN, Marc, F-35890 Luille (FR); BESSET, Jean-Claude, F-35580 Guichen (FR)
(86) Numéro de dépôt international: FR9902976
(87) Numéro de publication internationale: WO0033314

(56) Documents cités:
- US-A- 3 737 725
- PATENT ABSTRACTS OF JAPAN vol. 006, no. 145 (P-132), 4 août 1982 (1982-08-04) & JP 57 066589 A (FUJITSU LTD), 22 avril 1982 (1982-04-22)
- PATENT ABSTRACTS OF JAPAN vol. 018, no. 434 (E-1592), 12 août 1994 (1994-08-12) & JP 06 139916 A (FUJITSU TEN LTD), 20 mai 1994 (1994-05-20)

## Description

Le domaine de l'invention est celui des circuits électriques et/ou électroniques intégrés.

On connaît d'une part les systèmes de protection des systèmes fonctionnels contre des surtensions. A ce titre, on peut citer le brevet US3737725 qui décrit un système de protection contre les surtensions et qui comporte un fusible et une diode de type Zener disposés sur le circuit d'alimentation électrique du module fonctionnel.

D'autre part, les concepteurs de circuits électriques et/ou électroniques intégrés prévoient, outre les alimentations électriques, souvent des accès électriques à un ou plusieurs modules fonctionnels d'un système électrique et/ou électronique. De tels accès électriques avec l'extérieur s'avèrent par exemple nécessaires pour programmer ou configurer le module fonctionnel, pour introduire un code spécifique au système (et/ou à un utilisateur), ou encore pour tester, effectuer des mesures et/ou calibrer le module fonctionnel.

Lorsque la phase de test, de calibrage ou de programmation est terminée, il peut être souhaitable d'isoler efficacement le module fonctionnel de l'extérieur.

En d'autres termes, il est nécessaire de supprimer l'ACCÈS électrique avec l'extérieur, de façon à empêcher une modification de la programmation, de la configuration ou du codage, et/ou à assurer une meilleure protection du module fonctionnel, en particulier vis-à-vis des forts champs électromagnétiques et/ou des rayonnements ultraviolets, que l'on peut par exemple rencontrer en milieu industriel. Une telle isolation est également requise dans les environnements très hostiles tels que l'on peut en rencontrer dans les domaines spatial et nucléaire.

Diverses techniques ont déjà été proposées pour atteindre ce résultat. On connaît ainsi de nombreux dispositifs de programmation par isolation. Ils font généralement appel soit à des techniques de coupure physique de circuits, par exemple à l'aide de moyens mécaniques ou de moyens permettant d'appliquer des faisceaux laser, soit à la segmentation électrique, à l'aide d'interrupteurs à semi-conducteurs, ou par l'inhibition d'ACCÈS logiques à partir de la programmation de mémoires non volatiles.

La première méthode présente l'avantage de réaliser une coupure physique réelle de l'accès. En revanche, elle présente l'inconvénient de ne pouvoir être mise en oeuvre que lors du cycle de production du système électrique et/ou électronique, avant scellement du boîtier et/ou protection du système, par des résines ou vernis. Cette technique ne peut donc pas être mise en oeuvre par l'utilisateur final, qui ne peut donc pas effectuer les opérations de programmation, de configuration ou de test, citées ci-dessus.

Les secondes techniques, qui s'appuient sur la programmation de mémoires ou d'interrupteurs à semi-conducteurs présentent également plusieurs inconvénients. Tout d'abord, elles nécessitent l'emploi de composants sophistiqués, fragiles, relativement coûteux et parfois encombrants.

Par ailleurs, elles ne permettent pas de sécuriser efficacement leur propre programmation, en supprimant radicalement les chemins d'accès à celle-ci.

De plus, la technologie à base de cellules à grille flottante, généralement utilisée, présente l'inconvénient d'une sensibilité importante face aux environnements hostiles, aux forts champs électromagnétiques, et aux rayonnements ultraviolets.

La présente invention a notamment pour objectif de pallier ces différents inconvénients de l'état de la technique.

Plus précisément, l'un des objectifs de la présente invention est de fournir une technique permettant de supprimer, de manière efficace, l'accès électrique depuis l'extérieur à un module fonctionnel qu'il est souhaitable d'isoler (par exemple après une phase de test, de mesure, de calibrage, de programmation, de configuration, de codage....).

Un objectif supplémentaire de l'invention est de fournir une telle technique autorisant une utilisation dans des milieux hostiles et/ou en la présence de champ(s) électromagnétique(s) et/ou de rayonnements environnant(s) élevé(s).

Un autre objectif de l'invention est de fournir une telle technique dont le coût, la réalisation et/ou la mise en oeuvre sont réduits, par rapport aux techniques connues.

Un autre objectif de l'invention est de fournir un dispositif d'isolation électrique d'un module fonctionnel permettant la programmation du module fonctionnel (notamment la décision de l'instant de l'isolation) par l'utilisateur final.

Ces différents objectifs ainsi que d'autres qui apparaîtront par la suite, sont atteints, selon l'invention, à l'aide d'un système électrique et/ou électronique intégré, comprenant au moins un module fonctionnel connecté à une tension d'alimentation Val et relié par une broche à l'extérieur par un accès électrique,
caractérisé en ce qu'il comprend des moyens d'isolation électrique dudit accès électrique du module fonctionnel, comprenant :
- un fusible dont un premier pôle est connecté à ladite broche dudit module fonctionnel et le second pôle correspond audit accès électrique extérieur; et
- un premier dipôle à semi-conducteur amorçable sous l'effet d'une tension d'amorçage, dont un premier pôle est connecté au premier pôle dudit fusible et le second pôle est accessible à l'extérieur dudit système,
- un second dipôle dont le premier pôle est connecté à ladite broche du module fonctionnel et le second pôle est connecté à une tension prédéterminée,
de façon que l'application d'une tension d'isolation suffisante par rapport à ladite tension d'amorçage entre le second pôle dudit fusible et le second pôle dudit dipôle semi-conducteur amorçable entraîne la rupture physique dudit fusible, et par suite, le maintien exclusif via le second dipôle d'une tension prédéterminée sur ladite broche.
Ainsi, cette tension permet, après rupture dudit fusible, de contrôler le fonctionnement dudit module fonctionnel.

Le principe général de l'invention repose donc sur l'association de trois composants simples (un fusible, un dipôle à semi-conducteur amorçable et un second dipôle). Une telle association permet, par une commande interne ou externe de la rupture du fusible, d'isoler électriquement à l'instant voulu et d'une façon définitive, le module fonctionnel.
On peut donc ainsi programmer l'instant de la rupture du fusible soit par une intervention externe par exemple humaine en commandant manuellement une tension d'isolation adéquate ou par contrôle interne, l'apparition, par exemple, d'une ou plusieurs conditions particulières liées à l'environnement commandant la génération d'une tension d'isolation.

Il est important de noter que le franchissement d'une tension seuil (imposé par la présence du dipôle à semi-conducteur amorçable) est nécessaire pour qu'une interdiction à l'accès électrique au module fonctionnel soit programmée. Tant que la rupture du fusible n'a pas été effectuée, ni le fusible ni les dipôles ne perturbe le fonctionnement du système, et l'accès au module fonctionnel est direct

Du fait que l'on peut appliquer la tension d'isolation sur l'accès électrique depuis l'extérieur, ce système présente l'avantage de pouvoir être accessible, par l'utilisateur final, avant d'opérer la suppression de cet accès électrique interdisant tout accès électrique au module fonctionnel. Une telle interdiction d'accès électrique au module fonctionnel peut par exemple intervenir suite par exemple à la programmation ou au test du module fonctionnel.

On notera que la technique de l'invention peut aisément être dupliquée, dans un même système (accès à plusieurs modules et/ou plusieurs accès à un même module). Elle peut être facilement adaptée à l'isolation entre deux modules fonctionnels.
Le second dipôle permet de maintenir une tension prédéterminée sur l'accès audit module fonctionnel, après rupture dudit fusible. Ainsi, après rupture du fusible, l'entrée du module fonctionnel est configurée, de façon définitive, à une valeur donnée (qui peut indiquer notamment au module qu'il est désormais isolé).

Selon un premier mode de réalisation de l'invention, ladite tension prédéterminée est élaborée par des moyens 17 internes audit système et/ou correspond à un niveau logique prédéterminé.

Selon un premier mode de réalisation de l'invention, ledit niveau logique est "1", ladite broche étant reliée à une tension de polarisation dudit module fonctionnel, au moyen d'un élément présentant une résistance de valeur d'impédance équivalente suffisamment importante pour ne pas perturber le fonctionnement dudit accès électrique, avant la rupture dudit fusible.

Selon un second mode de réalisation de l'invention, ledit niveau logique est "0", ladite broche étant reliée à une tension de polarisation dudit module fonctionnel, au moyen d'un élément présentant une résistance de valeur d'impédance équivalente suffisamment importante pour ne pas perturber le fonctionnement dudit accès électrique, avant la rupture dudit fusible.

Avantageusement, ledit élément présentant une résistance appartient au groupe comprenant :
- les résistances ;
- les transistors de type MOSFET.

Cette liste n'est nullement limitative. On comprendra en effet que tout type de moyens présentant, dans les conditions de son fonctionnement et/ou de celui du système, une valeur d'impédance élevée peuvent convenir en tant qu'élément présentant une résistance.

De façon avantageuse, ledit dipôle à semi-conducteur amorçable appartient au groupe comprenant :
- les diodes de type "Zener" ;
- les diodes de type "transil".

Il est clair cependant que tout type de dipôles assurant, au cours de son fonctionnement, un état conducteur par l'application d'une tension d'isolation à ses bornes peut convenir.

Selon un mode de réalisation particulier de l'invention, ledit système comprend des moyens internes de génération de ladite tension d'isolation.

On notera que les moyens internes de génération de la tension d'isolation peuvent être notamment placés à l'intérieur du module fonctionnel.

Selon une variante de réalisation de l'invention, on peut prévoir des moyens externes de génération de la tension d'isolation, que l'utilisateur vient simplement appliquer sur les bornes du système.

Dans un mode de réalisation particulier de l'invention, ledit module fonctionnel comprend des moyens de contrôle desdits moyens internes de génération de ladite tension d'isolation.

Selon une variante de réalisation de l'invention, on peut envisager que les moyens de contrôle contrôlent des moyens externes de génération de la tension d'isolation.

Une telle caractéristique permet au système de fonctionner entièrement de manière autonome puisqu'il ne nécessite alors aucune commande externe supplémentaire.

Le fusible peut être réalisé à l'aide de tout type de matériau adéquat, et par exemple en un alliage nickel-chrome (ou NiCr) sur un substrat en verre et/ou alumine (ou Al₂O₃) et/ou céramique.

Avantageusement, ledit accès électrique est utilisé pour au moins une des opérations appartenant au groupe comprenant :
- la programmation dudit module fonctionnel ;
- la configuration dudit module fonctionnel ;
- le calibrage dudit module fonctionnel ;
- le relèvement des données ou des signaux dudit module fonctionnel ;
- le test dudit module fonctionnel ;
- l'introduction d'un code dans ledit module fonctionnel.

Il est clair que cette liste n'est cependant pas exhaustive.

Selon une variante avantageuse de l'invention, ledit système présente au moins deux accès électriques associés chacun à des moyens d'isolation distincts.

On comprendra que la présentation d'une pluralité d'accès électriques depuis l'extérieur au module fonctionnel implique de prévoir au moins un fusible sur chaque accès électrique.

Préférentiellement, ledit système appartient au groupe comprenant :
- les circuits intégrés (par exemple hybrides ou monolithiques); ;
- les circuits électroniques;
- les circuits électriques.

Cette liste n'est évidemment pas limitative.

L'invention concerne également un dispositif d'isolation électrique d'un accès électrique d'un module fonctionnel intégré dans un système électrique et/ou électronique, ledit module fonctionnel étant connecté à une tension d'alimentation et relié avec l'extérieur par un accès électrique via une broche.

Selon l'invention, ledit dispositif d'isolation comprend des moyens d'isolation électrique dudit module fonctionnel, comprenant :
- un fusible dont un premier pôle est connecté à ladite broche dudit module fonctionnel et le second pôle correspond audit accès électrique extérieur; et
- un dipôle à semi-conducteur amorçable sous l'effet d'une tension d'amorçage, dont un premier pôle est connecté au premier pôle dudit fusible et le second pôle est accessible à l'extérieur dudit dispositif,
- un second dipôle dont le premier pôle est connecté à ladite broche du module fonctionnel et le second pôle est connecté à une tension prédéterminée,
de façon que l'application d'une tension d'isolation suffisante par rapport à ladite tension d'amorçage entre le second pôle dudit fusible et le second pôle dudit dipôle à semisemi-conducteur amorçable entraîne la rupture physique dudit fusible, et par suite, le maintien exclusif via le second dipôle d'une tension prédéterminée sur ladite broche du module fonctionnel.
Cette tension permettant dès lors de contrôler le fonctionnement du module fonctionnel.

L'invention concerne aussi un procédé d'isolation électrique destiné à être mis en oeuvre par le système décrit précédemment. Selon l'invention, ledit procédé comprend une étape d'isolation électrique dudit module fonctionnel par l'application d'une tension d'isolation suffisante par rapport à ladite tension d'amorçage entre le second pôle dudit fusible et le second pôle dudit dipôle à semi-conducteur amorçable qui entraîne la rupture physique dudit fusible, et par suite, le maintien exclusif via le second dipôle d'une tension prédéterminée sur ladite broche du module fonctionnel, cette tension permettant de contrôler le fonctionnement dudit module fonctionnel.

L'invention peut notamment être utilisée dans un système électrique et/ou électronique intégré évoluant dans des champs électromagnétiques et/ou des rayonnements ultraviolets importants compris dans un environnement appartenant au groupe comprenant :
- les environnements industriels ;
- les environnements nucléaires ;
- les environnements spatiaux.

D'autres caractéristiques et avantages de l'invention apparaîtront à la lecture de la description suivante d'un mode de réalisation préférentiel de l'invention, donné à titre de simple exemple illustratif et non limitatif, et des dessins annexés, dans lesquels :
- la figure 1 présente un schéma de principe d'un système électrique et/ou électronique intégré à dispositif d'isolation électrique selon l'invention ; et
- la figure 2 présente un schéma simplifié d'un mode de réalisation particulier d'un système selon l'invention à dispositif d'isolation électrique d'un module fonctionnel intégré.

L'invention concerne donc un dispositif électrique et/ou électronique intégré permettant d'isoler un module fonctionnel préalablement accessible depuis l'extérieur, en en interdisant cet accès.

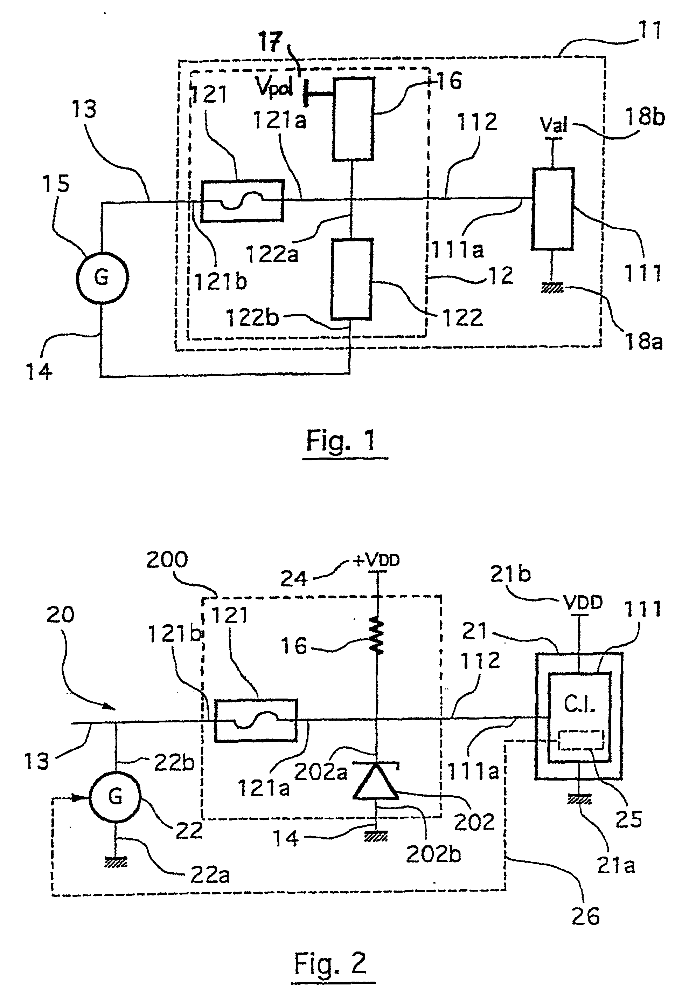

On présente maintenant, en relation avec le schéma de principe de la figure 1, un mode de réalisation particulier d'un système 11 électrique et/ou électronique intégré pourvu d'un dispositif 12 d'isolation électrique selon l'invention.

Le système 11 électrique et/ou électronique intégré comprend un dispositif 12 d'isolation et au moins un module 111 fonctionnel. Ce module 111 fonctionnel est un élément électrique et/ou électronique qui exerce au moins une fonction. Il peut par exemple utiliser, une commande, une valeur logique et/ou un code numérique délivré depuis l'extérieur au cours de son fonctionnement initial.

Pour ce faire, le module 111 fonctionnel est relié avec l'extérieur par une borne 13 électrique, via un accès 112 électrique. Il présente une grande impédance d'entrée (vis-à-vis de l'impédance du dispositif 12, à savoir celle d'un fusible 121 augmentée de celle d'un dipôle 122 à semi-conducteur amorçable dans son état passant et augmentée de l'impédance d'un dipôle 16 connecté à une tension de polarisation tels que décrits plus loin), de sorte que le module 111 fonctionnel ne soit pas perturbé par l'application de la tension d'isolation. Le module 111 fonctionnel est connecté par ailleurs, à une masse 18a et à une tension 18b d'alimentation Vₐₗ.

L'accès 13 électrique au module 111 fonctionnel est utilisé par exemple pour au moins une des opérations suivantes :
- programmer le module 111 fonctionnel ;
- configurer le module 111 fonctionnel ;
- calibrer le module 111 fonctionnel ;
- relever des données ou des signaux du module 111 fonctionnel ;
- tester le module 111 fonctionnel ;
- introduire un code numérique dans le module 111 fonctionnel.

Selon l'invention, le système 11 comprend des moyens 12 d'isolation électrique du module 111 fonctionnel, comprenant :
- un fusible 121 dont un premier pôle 12 la est connecté à une broche 111a du module 111 fonctionnel et le second pôle 121b correspond à l'accès 13 électrique extérieur. La broche 111a est une entrée et/ou une sortie du module 111 fonctionnel ; et
- un dipôle 122 à semi-conducteur amorçable sous l'effet d'une tension d'amorçage, dont un premier pôle 122a est connecté au premier pôle 121a du fusible 121 et le second pôle 122b est accessible, via un accès 14 électrique, à l'extérieur du système 11 ; et
- un second dipôle 16 dont le premier pôle est connecté à ladite broche 111a du module fonctionnel et le second pôle est connecté à une tension 17 prédéterminée sur la broche 111a.

C'est ainsi une association d'un fusible 121 et des dipôles 122 et 16 qui permet, par le contrôle de la rupture du fusible 121, de réaliser une isolation du module 111 tout en permettant la poursuite du fonctionnement de ce module dans des conditions nominales puisqu'il conserve son alimentation électrique 18b et sa polarisation au niveau de l'accès 111a. Pour ce faire, le contrôle de la rupture du fusible s'exerce à l'aide de moyens 15 de génération de la tension d'isolation situés par exemple à l'extérieur du système 11 électrique et/ou électronique.

Les moyens 15 de génération de la tension d'isolation sont connectés par exemple entre les accès 13, 14 électriques extérieurs. Ils présentent une faible impédance de sortie par rapport à celle du fusible 121 augmentée de celle du dipôle 122 à semi-conducteur amorçable lorsque ce dernier est amorcé et augmentée de l'impédance du dipôle 16 polarisé, de sorte que les moyens 15 de génération d'une tension n'empêchent pas un bon fonctionnement des moyens 12 d'isolation. Le fait que les moyens 15 de génération soient externes, permet, à un utilisateur du système 11, de venir commander l'isolation du module 111 fonctionnel, à tout moment, sans utiliser de moyens éventuellement complexes à l'intérieur du système 11.

Cependant, bien sûr, les moyens 15 de génération peuvent également être internes au système 11, (comme illustré en figure 2) ce qui présente l'avantage de ne nécessiter aucun équipement externe pour générer la tension d'isolation.

On notera que l'isolation du module fonctionnel est possible malgré que l'un des pôles du fusible, à savoir celui connecté au module fonctionnel, est inaccessible de l'extérieur.

Cette isolation est donc obtenue par l'application d'une tension, qui franchit la tension seuil (tension d'amorçage) caractérisant le dipôle 122 à semi-conducteur amorçable, provoque le passage à l'état passant du dipôle 122 à semi-conducteur. Cela entraîne simultanément le passage du courant au travers du fusible 121. L'intensité du courant traversant le fusible 121 atteint alors un courant de claquage du fusible 121, qui cause la rupture physique du fusible 121.

Tout passage d'un signal électrique en direction du module 111 fonctionnel (via les accès 13, 112 électriques) est alors clairement impossible. Le module 111 fonctionnel est donc isolé vis-à-vis de tout accès électrique extérieur.

La présente invention propose donc une architecture simple et performante pour interdire l'accès électrique à un module 111 fonctionnel.

Après l'ouverture du fusible 121, les moyens 16, 17 maintiennent une tension prédéterminée sur l'accès 112 électrique au module iii fonctionnel, après la rupture du fusible 121. Cette tension prédéterminée peut correspondre à un niveau logique prédéterminé, tel que par exemple un niveau haut à "1"ou un niveau bas à "0".

Selon une première situation, la broche 111a est reliée à une tension 17 de polarisation du module 111 fonctionnel, de façon que le niveau logique est à"1", au moyen d'un élément 16 présentant une résistance présentant une valeur d'impédance équivalente suffisamment importante pour ne pas perturber le fonctionnement de l'accès 112 électrique au module 111 fonctionnel, avant la rupture du fusible 121.

Selon la seconde situation, pour que le niveau logique soit à "0", on relie la broche 111a à une tension de polarisation du module fonctionnel, au moyen d'un élément 16 présentant une résistance de valeur d'impédance équivalente suffisamment importante pour ne pas perturber le fonctionnement de l'accès 112 électrique au module 111 fonctionnel, avant la rupture du fusible 121.

Toute autre tension non forcément significative d'une valeur logique peut être appliquée de la même façon. Cette tension est irréversible dans le cadre de cet exemple de réalisation.

Selon une variante de réalisation de l'invention (non représentée), le système 11 présente une pluralité d'accès électriques équipés chacun d'un fusible, de façon a fournir plusieurs accès à un ou plusieurs modules fonctionnels.

On présente maintenant, en relation avec le schéma simplifié de la figure 2, un mode de réalisation particulier d'un système 20 selon l'invention d'isolation électrique d'un module 111 fonctionnel intégré pourvu d'un dispositif 200 d'isolation électrique. Ce système 20 est intégré par exemple dans un système électrique et/ou électronique (non représenté).

Les éléments décrits en relation avec la figure 1 conservent les mêmes références. On ne décrit ici que les aspects spécifiques de ce mode de réalisation.

L'élément 16 présentant une résistance de la figure 1 est une résistance 16 de tirage, ayant une impédance élevée, par exemple de quelques centaines de Kohms. Selon une variante de réalisation, on peut envisager, par exemple, un transistor de type MOSFET, qui présente également une impédance relativement élevée.

Le dipôle 122 à semi-conducteur amorçable de la figure 1 est ici une diode 202 de type "Zener" polarisée en inverse. L'anode de la diode 202 "Zener" est reliée à la masse 202b et la cathode 202a est reliée d'une part à la borne 121a du fusible 121 et la résistance 16 de tirage, et d'autre part à l'accès 112 électrique au module 111 fonctionnel.

Tant que la tension appliquée aux bornes de la diode 202 "Zener" est inférieure à sa tension d'amorçage, aucun courant ne la traverse. Pour rendre passante la diode 202 "Zener", des moyens 22 internes (c'est-à-dire intégrés au système 20 d'isolation électrique) de génération de la tension d'isolation supérieure à la tension d'amorçage appliquent une tension positive d'isolation, par exemple supérieure à 6 Volts. Selon une variante de réalisation de l'invention (non représentée), les moyens 22 internes sont par exemple inclus dans le module 111 fonctionnel.

Selon une variante préférentielle de réalisation de l'invention (représentée en pointillés sur la figure 2), le module 111 fonctionnel comprend des moyens 25 de contrôle des moyens 22 internes de génération de la tension d'isolation. Pour ce faire, ces moyens 25 de contrôle délivrent un signal de commande destiné aux moyens 22 internes de génération de la tension d'isolation, via une liaison 26. Ce signal de commande entraîne l'activation des moyens 22 internes de génération de la tension d'isolation. Ce signal peut notamment être commandé après détection d'un environnement hostile.

Il est clair que la tension d'amorçage limitée par la diode 202 "Zener", doit rester inférieure à la tension maximale admissible en entrée du module 111 fonctionnel, afin que l'application de la tension d'isolation ne fragilise pas ce dernier.

La tension appliquée par les moyens 22 de génération de la tension d'isolation peut se présenter par exemple sous forme continue et/ou sous forme d'une ou plusieurs impulsion(s).

Selon une variante de réalisation, on peut polariser la diode "Zener" en direct, de sorte que les moyens de génération de la tension d'isolation doivent générer une surtension négative d'isolation, par exemple inférieure à "- 6Volts" pour rendre la diode conductrice.

Selon une autre variante de réalisation de l'invention (non représentée), le dipôle 202 à semi-conducteur amorçable est une diode de type "transil".

Après la rupture du fusible 121, la diode 202 "Zener" revient dans l'état bloqué qu'elle occupait avant l'application de la surtension positive d'isolation, suite à la rupture du fusible 121.

Le fusible 121 est, quant à lui, par exemple réalisé en un alliage nickel-chrome (NiCr). Le fusible 121 est conçu de façon à se rompre lorsqu'une surintensité de courant traverse ses deux pôles 121a, 121b. Cette surintensité de courant est fournie au fusible 121 suite à l'amorçage de la diode 202 "Zener".

Dans le mode de réalisation illustré, on peut par exemple utiliser un fusible réalisé en un alliage NiCr de largeur 16 mm, de longueur 30 mm et d'épaisseur 15 nm sur un substrat :
- en verre, qui présente une résistance sensiblement égale à 190 ohms (correspondant à 100 ohms/carré) et se rompt sous l'effet d'un courant minimal d'environ 25 mA ; ou
- en alumine Al₂O₃, qui présente une résistance sensiblement égale à 130 ohms (correspondant à 70 ohms/carré) et se rompt sous l'effet d'un courant minimal d'environ 60 mA.

Selon des variantes de réalisation, le fusible 121 peut être réalisé en un alliage nickel-chrome sur un substrat en céramique.

On comprend que le fusible 121 présente une résistance choisie de façon qu'il ne claque pas lors de l'étape préalable de programmation, de test, de calibrage, de configuration....

La résistance 16 de tirage, alimentée par une tension 24 d'alimentation VDD par exemple de 5 Volts, maintient un niveau logique à "1" en entrée du module 111 fonctionnel, après la rupture du fusible 121.

Le module 111 fonctionnel est par exemple un circuit intégré de type CMOS et est alimenté entre une tension 21b d'alimentation V_{DD} égale à 5 Volts et une masse 21a.

Le système 20 de l'invention peut également être un :
- circuit intégré de tout type (notamment un circuit intégré hybride ou un circuit intégré monolithique) ;
- circuit électronique ;
- circuit électrique.

Dans le cas d'un circuit électronique, celui-ci est éventuellement protégé par au moins un matériau de revêtement, tel qu'une ou plusieurs couche(s) de vernis et/ou une ou plusieurs couche(s) de résine.

Par ailleurs, dans le cas d'un circuit électrique, ce dernier peut être clos ou scellé.

L'invention concerne également un procédé d'isolation d'un module fonctionnel, mis en oeuvre par les moyens 12, 200 discutés ci-dessus. Ce procédé comprend une étape d'isolation électrique du module fonctionnel par l'application d'une tension d'isolation suffisante par rapport à la tension d'amorçage entre le second pôle du fusible et le second pôle du dipôle à semi-conducteur amorçable pour entraîner la rupture physique du fusible, et par suite, le maintien exclusif et irréversible via le second dipôle d'une tension prédéterminée sur ladite broche du module fonctionnel, ladite tension permettant dès lors de contrôler le fonctionnement dudit module fonctionnel.

On peut notamment utiliser le dispositif et/ou le système de l'invention dans certains systèmes comprenant au moins un dispositif programmable et évoluant dans des champs électromagnétiques et/ou des rayonnements ultraviolets importants et générés notamment dans les environnements industriels, nucléaires et/ou spatiaux.

## Revendications

1. Système (11 ; 20) électrique et/ou électronique intégré, comprenant, au moins un module (111) fonctionnel connecté à une tension d'alimentation (Val) et relié par une broche (111a) à l'extérieur par un accès électrique (13), et des moyens (12) d'isolation électrique dudit module (111) fonctionnel, avec un fusible (121) dont un premier pôle (121a) est connecté à une broche (111a) dudit module (111) fonctionnel et le second pôle (121b) correspond audit accès (13) électrique extérieur, et un dipôle (122) à semi-conducteur amorçable sous l'effet d'une tension d'amorçage, dont un premier pôle (122a) est connecté au premier pôle (121a) dudit fusible (121) et le second pôle (122b) est accessible à l'extérieur dudit système (11), ***caractérisé en ce qu*'**il comprend comme autre moyen (12) d'isolation électrique dudit module (111) fonctionnel, un second dipôle (16) dont le premier pôle est connecté à ladite broche (111a) du module fonctionnel (111) et le second pôle est connecté à une tension (17, 24) prédéterminée, de façon que l'application d'une tension d'isolation suffisante par rapport à ladite tension d'amorçage entre le second pôle (121b) dudit fusible (121) et le second pôle (122b) dudit dipôle (122) à semi-conducteur amorçable entraîne la rupture physique dudit fusible (121), et par suite, le maintien exclusif via le second dipôle d'une tension prédéterminée sur ladite broche (111a).

2. Système (11 ; 20) électrique et/ou électronique intégré selon la revendication 1, ***caractérisé en ce qu*** 'il comprend des moyens (15, 22) internes de génération de la tension d'isolation.

3. Système (11 ; 20) électrique et/ou électronique intégré selon la revendication 1, ***caractérisé en ce qu'**il* comprend des moyens externes de génération de la tension d'isolation.

4. Système (11 ; 20) selon l'une quelconque des revendications 2 et 3, ***caractérisé en ce que*** ledit module (111) fonctionnel comprend des moyens (25) de contrôle pour la validation et/ou de l'inhibition desdits moyens de génération de ladite tension d'isolation.

5. Système (11 ; 20) selon l'une quelconque des revendications 1 à 3, ***caractérisé en ce que**,* après rupture dudit fusible (121), ladite tension (17, 24) prédéterminée sur ladite broche (111a) du module fonctionnel correspond à un niveau logique prédéterminé.

6. Système (11 ; 20) selon la revendication 5, ***caractérisé en ce que*** ledit niveau logique est "1", ladite broche (111a) étant reliée à une tension (17, 24) de polarisation dudit module (111) fonctionnel, au moyen d'un élément (16) présentant une résistance présentant une valeur d'impédance équivalente suffisamment importante pour ne pas perturber le fonctionnement dudit accès (13) électrique, avant la rupture dudit fusible (121).

7. Système (11 ; 20) selon la revendication 5, ***caractérisé en ce que*** ledit niveau logique est "0", ladite broche (111a) étant reliée à une tension (17) de polarisation dudit module (111) fonctionnel, au moyen d'un élément (16) présentant une résistance présentant une valeur d'impédance équivalente suffisamment importante pour ne pas perturber le fonctionnement dudit accès (13) électrique, avant la rupture dudit fusible (121).

8. Système (11 ; 20) selon l'une quelconque des revendications 6 et 7, ***caractérisé en ce que*** ledit élément (16) présentant une résistance appartient au groupe comprenant :
- les résistances,
- les transistors de type MOSFET.

9. Système (11 ; 20) selon l'une quelconque des revendications 1 à 8, ***caractérisé en ce que*** ledit dipôle (122 ; 202) à semi-conducteur amorçable appartient au groupe comprenant :
- les diodes de type "Zener",
- les diodes de type "transil".

10. Système (11 ; 20) selon l'une quelconque des revendications 1 à 9, ***caractérisé en ce que*** ledit fusible (121) est réalisé en un alliage nickel-chrome sur un substrat comprenant au moins un matériau appartenant au groupe comprenant :
- les verres,
- les alumines,
- les céramiques.

11. Système (11 ; 20) selon l'une quelconque des revendications 1 à 10, ***caractérisé en ce que*** ledit accès (13) électrique est utilisé pour au moins une des opérations appartenant au groupe comprenant
- la programmation dudit module (111) fonctionnel,
- la configuration dudit module (111) fonctionnel,
- le calibrage dudit module (111) fonctionnel,
- le relèvement des données ou des signaux dudit module (111) fonctionnel,
- le test dudit module (111) fonctionnel,
- l'introduction d'un code dans ledit module (111) fonctionnel.

12. Système (11 ; 20) selon l'une quelconque des revendications 1 à 11, ***caractérisé en ce qu'***il présente au moins deux accès électriques associés chacun à des moyens d'isolation distincts.

13. Système (11 ; 20) selon l'une quelconque des revendications 1 à 12, ***caractérisé en ce qu'***il appartient au groupe comprenant :
- les circuits intégrés hybrides,
- les circuits intégrés monolithiques,
- les circuits électroniques,
- les circuits électriques.

14. Dispositif (12 ; 200) d'isolation électrique d'un module (111) fonctionnel intégré dans un système électrique et/ou électronique, ledit module (111) fonctionnel, étant connecté à une tension d'alimentation (val) et relié avec l'extérieur par un accès (13) électrique via une broche (111a), et comprenant comme moyen d'isolation électrique dudit module (111) fonctionnel, un fusible (121) dont un premier pôle (121a) est connecté à ladite broche (111a) dudit module (111) fonctionnel et le second pôle (121b) correspond audit accès (13) électrique extérieur, et un dipôle (122, 202) à semi-conducteur amorçable sous l'effet d'une tension d'amorçage, dont un premier pôle (122a, 202a) est connecté au premier pôle (121a) dudit fusible (121) et le second pôle (122b, 202b), est accessible à l'extérieur du dispositif (12, 200), ***caractérisé en ce qu***'il comprend comme autre moyen d'isolation électrique dudit module (111) fonctionnel, un second dipôle (16) dont le premier pôle est connecté à ladite broche (111a) du module fonctionnel (111) et le second pôle est connecté à une tension (17, 24) prédéterminée, de façon que l'application d'une tension d'isolation suffisante par rapport à ladite tension d'amorçage entre le second pôle (121b) dudit fusible (121) et le second pôle (122b, 202b) dudit dipôle (122, 202) à semi-conducteur amorçable entraîne la rupture physique dudit fusible (121), et par suite, le maintien exclusif via le second dipôle (16, 17, 24) d'une tension prédéterminée sur ladite broche (111a)

15. Procédé d'isolation électrique d'un module (111) fonctionnel intégré dans un système (11 ; 20) électrique et/ou électronique, ledit module (111) fonctionnel étant connecté à une tension d'alimentation (val) et relié avec l'extérieur par un accès (13) électrique via une broche (111a), ledit système (11 ; 20) comportant un fusible (121) dont un premier pôle (121a) est connecté à une broche (111a) dudit module (111) fonctionnel et le second pôle (121b) correspond audit accès (13) électrique extérieur et un dipôle (122, 202) à semi-conducteur amorçable sous l'effet d'une tension d'amorçage, dont un premier pôle (122a, 202a) est connecté au premier pôle (121a) dudit fusible (121) et le second pôle (122b, 202b) est accessible à l'extérieur du système (11 ; 20), ***caractérisé en ce qu'**on* prévoit aussi dans ledit système (11 ; 20), un second dipôle (16) dont le premier pôle est connecté à ladite broche (111a) du module fonctionnel (111) et le second pôle est connecté à une tension (17, 24) prédéterminée, *et **en ce qu'**il* comprend une étape d'isolation électrique dudit module (111) fonctionnel par l'application d'une tension d'isolation suffisante par rapport à ladite tension d'amorçage entre le second pôle (121b) dudit fusible (121) et le second pôle (122b ; 202b) dudit dipôle (122 ; 202) à semi-conducteur amorçable qui entraîne la rupture physique dudit fusible (121), et par suite, le maintien exclusif via le second dipôle d'une tension prédéterminée sur la broche (111a) du module fonctionnel (111), cette tension permettant de contrôler le fonctionnement dudit module (111) fonctionnel.

16. Utilisation d'un dispositif (12) d'isolation électrique selon la revendication 14 dans un système électrique et/ou électronique intégré évoluant dans des champs électromagnétiques et/ou des rayonnements ultraviolets importants compris dans un environnement appartenant au groupe comprenant :
- les environnements industriels,
- les environnements nucléaires,
- les environnements spatiaux.

## Claims

1. Integrated electronic and/or electrical system (11; 20), comprising at least one operating module (111) which is connected to a supply voltage (Val) and is connected by a pin (111a) to the exterior by an electrical access (13), and means (12) for electrical isolation of the said electrical access of the operating module (111), with a fuse (121), a first pole (121a) of which is connected to a pin (111a) of the said operating module (111) and the second pole (121b) corresponds to the said external electrical access (13), and a semi-conductor dipole (122) which can be activated under the effect of an activation voltage, a first pole (122a) of which is connected to the first pole (121a) of the said fuse (121) and the second pole (122b) is accessible to the exterior of the said system (11), **characterised in that** it comprises as another means (12) for electrical isolation of the said operating module (111) a second dipole (16), the first pole of which is connected to the said pin (111a) of the operating module (111) and the second pole is connected to a predetermined voltage (17, 24), such that the application of an isolation voltage which is great enough relative to the said activation voltage between the second pole (121b) of the said fuse (121) and the second pole (122b) of the said semi-conductor dipole (122) which can be activated gives rise to physical rupture of the said fuse (121), and subsequently to maintenance exclusively via the second dipole of a predetermined voltage at the said pin (111a).

2. Integrated electronic and/or electrical system (11; 20) according to claim 1, **characterised in that** it comprises internal means (15, 22) for generation of the isolation voltage.

3. Integrated electronic and/or electrical system (11; 20) according to claim 1, **characterised in that** it comprises external means (15, 22) for generation of the isolation voltage.

4. System (11; 20) according to claim 2 or claim 3, **characterised in that** the said operating module (111) comprises control means (25) for validation and/or inhibition of the said means for generation of the said isolation voltage.

5. System (11; 20) according to any one of claims 1 to 3, **characterised in that**, after the said fuse (121) has ruptured, the said predetermined voltage (17, 24) at the said pin (111a) of the functional module corresponds to a predetermined logic level.

6. System (11, 20) according to claim 5, **characterised in that** the said logic level is "1", the said pin (111a) being connected to a polarisation voltage (17, 24) of the said operating module (111), by means of an element (16) which has a resistor with an equivalent impedance value which is great enough not to disrupt the operation of the said electrical access (13) before the said fuse (121) ruptures.

7. System (11, 20) according to claim 5, **characterised in that** the said logic level is "0", the said pin (111a) being connected to a polarisation voltage (17) of the said operating module (111), by means of an element (16) which has a resistor with an equivalent impedance value which is great enough not to disrupt the operation of the said electrical access (13) before the said fuse (121) ruptures.

8. System according to claim 6 or claim 7, **characterised in that** the said element (16) has a resistor which belongs to the group comprising:
- resistors;
- transistors of the MOSFET type.

9. System (11; 20) according to any one of claims 1 to 8, **characterised in that** the said semi-conductor dipole (122; 202) which can be activated belongs to the group comprising:
- diodes of the "Zener" type;
- diodes of the "transil" type.

10. System (11; 20) according to any one of claims 1 to 9, **characterised in that** the said fuse (121) is made of a nickel-chromium alloy on a substrate comprising at least one material belonging to the group comprising:
- glasses;
- aluminas;
- ceramics.

11. System (11; 20) according to any one of claims 1 to 10, **characterised in that** the said electrical access (13) is used for at least one of the operations which belong to the group comprising:
- programming of the said operating module (111) ;
- configuration of the said operating module (111) ;
- calibration of the said operating module (111) ;
- reading of data or signals of the said operating module (111) ;
- testing of the said operating module (111); and
- entering of a code in the said operating module (111).

12. System (11; 20) according to any one of claims 1 to 11, **characterised in that** it has at least two electrical accesses which are each associated with separate means for isolation.

13. System (11; 20) according to any one of claims 1 to 12, **characterised in that** it belongs to the group comprising:
- hybrid integrated circuits;
- monolithic integrated circuits;
- electronic circuits;
- electrical circuits.

14. Device (12; 200) for electrical isolation of an integrated operating module (111) in an electronic and/or electrical system, the said operating module (111) being connected to a supply voltage (val) and connected to the exterior by an electrical access (13) via a pin (111a), and comprising as means for electrical isolation of the said operating module (111) a fuse (121), a first pole (121a) of which is connected to the said pin (111a) of the said operating module (111) and the second pole (121b) corresponds to the said external electrical access (13), and a semi-conductor dipole (122, 202) which can be activated under the effect of an activation voltage, a first pole (122a, 202a) of which is connected to the first pole (121a) of the said fuse (121) and the second pole (122b, 202b) is accessible to the exterior of the device (12, 200), **characterised in that** it comprises as another means for electrical isolation of the said operating module (111) a second dipole (16), the first pole of which is connected to the said pin (111a) of the operating module (111) and the second pole is connected to a predetermined voltage (17, 24), such that the application of an isolation voltage which is great enough relative to the said activation voltage between the second pole (121b) of the said fuse (121) and the second pole (122b, 202b) of the said semi-conductor dipole (122, 202) which can be activated gives rise to physical rupture of the said fuse (121), and subsequently to maintenance exclusively via the second dipole (16, 17, 24) of a predetermined voltage at the said pin (111a).

15. Method for electrical isolation of an integrated operating module (111) in an electronic and/or electrical system (11; 20), the said operating module (111) being connected to a supply voltage (val) and connected to the exterior by an electrical access (13) via a pin (111a), the said system (11; 20) comprising a fuse (121), a first pole (121a) of which is connected to a pin (111a) of the said operating module (111) and the second pole (121b) corresponds to the said external electrical access (13), and a semi-conductor dipole (122, 202) which can be activated under the effect of an activation voltage, a first pole (122a, 202a) of which is connected to the first pole (121a) of the said fuse (121) and the second pole (122b, 202b) is accessible to the exterior of the system (11; 20), **characterised in that** the said system (11; 20) also comprises a second dipole (16), the first pole of which is connected to the said pin (111a) of the operating module (111) and the second pole is connected to a predetermined voltage (17, 24), and **in that** it comprises a step of electrical isolation of the said operating module (111) by application of an isolation voltage which is great enough relative to the said activation voltage between the second pole (121b) of the said fuse (121) and the second pole (122b, 202b) of the said semi-conductor dipole (122, 202) which can be activated, to give rise to physical rupture of the said fuse (121), and subsequently to maintenance exclusively via the second dipole of a predetermined voltage at the said pin (111a) of the operating module (111), this voltage making it possible to control the operation of the said operating module (111).

16. Use of a device (12) for electrical isolation according to claim 14, in an integrated electronic and/or electrical system developed in electromagnetic fields and/or in substantial ultraviolet radiation contained in an environment belonging to the group comprising:
- industrial environments;
- nuclear environments;
- spatial environments.

## Patentansprüche

1. Elektrisches und/oder elektronisches integriertes System (11, 20) mit mindestens einem Funktionsbaustein (111), der mit einer Versorgungsspannung (Val) verbunden ist und über einen Stift (111a) mit dem Äußeren durch einen elektrischen Zugang (13) verbunden ist, und mit Mitteln (12) zum elektrischen Isolieren des Funktionsbausteins (111) mit einer Schmelzssicherung (121), von welcher ein erster Pol (121a) mit einem Stift (111a) des Funktionsbausteins (111) verbunden ist und der zweite Pol (121b) dem äußeren elektrischen Zugang (13) entspricht, und einem Halbleiter-Dipol (122), der unter der Wirkung einer Ansprechspannung erregbar ist, von welchem ein erster Pol (122a) mit dem ersten Pol (121a) der Schmelzssicherung (121) verbunden ist und der zweite Pol (122b) an der Außenseite des Systems (11) zugänglich ist, **dadurch gekennzeichnet, daß** es als weiteres Mittel (12) zum elektrischen Isolieren des Funktionsbausteins (111) einen zweiten Dipol (16) umfaßt, dessen erster Pol mit dem Stift (111a) des Funktionsbausteins (111) verbunden ist und dessen zweiter Pol mit einer vorbestimmten Spannung (17, 24) verbunden ist, damit das Anlegen einer ausreichenden Isolationsspannung bezüglich der Ansprechspannung zwischen dem zweiten Pol (121b) der Schmelzsicherung (121) und dem zweiten Pol (122b) des erregbaren Halbleiter-Dipols (122) zum physischen Bruch der Schmelzsicherung (121) und folglich zur Aufrechterhaltung einer vorbestimmten Spannung an dem Stift (111a) ausschließlich über den zweiten Dipol führt.

2. Elektrisches und/oder elektronisches integriertes System (11; 20) nach Anspruch 1, **dadurch gekennzeichnet, daß** es interne Mittel (15, 22) zum Erzeugen der Isolationsspannung umfaßt.

3. Elektrisches und/oder elektronisches integriertes System (11; 20) nach Anspruch 1, **dadurch gekennzeichnet, daß** es externe Mittel zum Erzeugen der Isolationsspannung umfaßt.

4. System (11; 20) nach einem der Ansprüche 2 und 3, **dadurch gekennzeichnet, daß** der Funktionsbaustein (111) Steuermittel (25) für die Freigabe und/oder zur Sperrung der Mittel zum Erzeugen der Isolationsspannung umfaßt.

5. System (11; 20) nach einem der Ansprüche 1 bis 3, **dadurch gekennzeichnet, daß** nach dem Bruch der Schmelzsicherung (121) die vorbestimmte Spannung (17, 24) an dem Stift (111a) des Funktionsbausteins einem vorbestimmten logischen Pegel entspricht.

6. System (11; 20) nach Anspruch 5, **dadurch gekennzeichnet, daß** der logische Pegel "1" ist, wobei der Stift (111a) mit einer Basisvorspannung (17, 24) des Funktionsbausteins (111) mit Hilfe eines Elements (16) verbunden ist, das einen Widerstand aufweist, der einen äquivalenten Impedanzwert aufweist, der groß genug ist, um die Funktion des elektrischen Zugangs (13) vor dem Bruch der Schmelzsicherung (121) nicht zu stören.

7. System (11; 20) nach Anspruch 5, **dadurch gekennzeichnet, daß** der logische Pegel "0" ist, wobei der Stift (111a) mit einer Basisvorspannung (17) des Funktionsbausteins (111) mit Hilfe eines Elements (16) verbunden ist, das einen Widerstand aufweist, der einen äquivalenten Impedanzwert aufweist, der groß genug ist, um die Funktion des elektrischen Zugangs (13) vor dem Bruch der Schmelzsicherung (121) nicht zu stören

8. System (11; 20) nach einem der Ansprüche 6 und 7, **dadurch gekennzeichnet, daß** das Element (16), das einen Widerstand aufweist, zu der Gruppe gehört, die:
- Widerstände und
- MOSFETs umfaßt.

9. System (11; 20) nach einem der Ansprüche 1 bis 8, **dadurch gekennzeichnet, daß** der erregbare Halbleiter-Dipol (122; 202) zu der Gruppe gehört, die:
- Zener- Dioden und
- Transil- Dioden umfaßt.

10. System (11; 20) nach einem der Ansprüche 1 bis 9, **dadurch gekennzeichnet, daß** die Schmelzsicherung (121) aus einer Nickel-Chrom-Legierung auf einem Substrat besteht, das mindestens ein Material umfaßt, das zu der Gruppe gehört, die:
- Gläser,
- Aluminiumoxide und
- Keramiken.

11. System (11; 20) nach einem der Ansprüche 1 bis 10, **dadurch gekennzeichnet, daß** der elektrische Zugang (13) für mindestens einen der Vorgänge verwendet wird, die zu der Gruppe gehören, die folgendes umfaßt:
- die Programmierung des Funktionsbausteins (111),
- die Konfiguration des Funktionsbausteins (111),
- die Kalibrierung des Funktionsbausteins (111),
- die Ablesung der Daten oder der Signale des Funktionsbausteins (111),
- die Prüfung des Funktionsbausteins (111),
- die Einführung eines Codes in den Funktionsbaustein (111).

12. System (11; 20) nach einem der Ansprüche 1 bis 11, **dadurch gekennzeichnet, daß** es mindestens zwei elektrische Zugänge aufweist, die jeweils mit unterschiedlichen Isolationsmitteln verbunden sind.

13. System (11; 20) nach einem der Ansprüche 1 bis 12, **dadurch gekennzeichnet, daß** es zu der Gruppe gehört, die folgendes umfaßt:
- die integrierten Hybrid-Schaltkreise,
- die integrierten monolithischen Schaltkreise,
- die elektronischen Schaltkreise,
- die elektrischen Schaltkreise.

14. Vorrichtung (12; 200) zum elektrischen Isolieren eines Funktionsbausteins (111), der in ein elektrisches und/oder elektronisches System integriert ist, wobei der Funktionsbaustein (111) mit einer Versorgungsspannung (Val) verbunden ist und mit dem Äußeren durch einen elektrischen Zugang (13) über einen Stift (111a) verbunden ist, und welche als Mittel zum elektrischen Isolieren des Funktionsbausteins (111) eine Schmelzssicherung (121), von welcher ein erster Pol (121a) mit dem Stift (111a) des Funktionsbausteins (111) verbunden ist und der zweite Pol (121b) dem äußeren elektrischen Zugang (13) entspricht, und einen Halbleiter-Dipol (122, 202) aufweist, der unter der Wirkung einer Ansprechspannung erregbar ist, von welchem ein erster Pol (122a, 202a) mit dem ersten Pol (121a) der Schmelzssicherung (121) verbunden ist und der zweite Pol (122b, 202b) an der Außenseite der Vorrichtung (12, 200) zugänglich ist, **dadurch gekennzeichnet, daß** sie als weiteres Mittel zum elektrischen Isolieren des Funktionsbausteins (111) einen zweiten Dipol (16) aufweist, dessen erster Pol mit dem Stift (111a) des Funktionsbausteins (111) verbunden ist und dessen zweiter Pol mit einer vorbestimmten Spannung (17, 24) verbunden ist, damit das Anlegen einer ausreichenden Isolationsspannung bezüglich der Ansprechspannung zwischen dem zweiten Pol (121b) der Schmelzsicherung (121) und dem zweiten Pol (122b, 202b) des erregbaren Halbleiter-Dipols (122, 202) zum physischen Bruch der Schmelzsicherung (121) und folglich zur Aufrechterhaltung einer vorbestimmten Spannung an dem Stift (111a) ausschließlich über den zweiten Dipol (16, 17, 24) führt.

15. Verfahren zum elektrischen Isolieren eines Funktionsbausteins (111), der in ein elektrisches und/oder elektronisches System (11; 20) integriert ist, wobei der Funktionsbaustein (111) mit einer Versorgungsspannung (Val) verbunden ist und mit dem Äußeren durch einen elektrischen Zugang (13) über einen Stift (111a) verbunden ist, wobei das System (11; 20) eine Schmelzssicherung (121), von welcher ein erster Pol (121a) mit einem Stift (111a) des Funktionsbausteins (111) verbunden ist und der zweite Pol (121b) dem äußeren elektrischen Zugang (13) entspricht, und einen Halbleiter-Dipol (122, 202) aufweist, der unter der Wirkung einer Ansprechspannung erregbar ist, von welchem ein erster Pol (122a, 202a) mit dem ersten Pol (121a) der Schmelzssicherung (121) verbunden ist und der zweite Pol (122b, 202b) an der Außenseite des Systems (11; 20) zugänglich ist, **dadurch gekennzeichnet, daß** in dem System (11; 20) auch ein zweiter Dipol (16) vorgesehen ist, dessen erster Pol mit dem Stift (111a) des Funktionsbausteins (111) verbunden ist und dessen zweiter Pol mit einer vorbestimmten Spannung (17, 24) verbunden ist, und daß es einen Schritt der elektrischen Isolation des Funktionsbausteins (111) durch das Anlegen einer ausreichenden Isolationsspannung bezüglich der Ansprechspannung zwischen dem zweiten Pol (121b) der Schmelzsicherung (121) und dem zweiten Pol (122b; 202b) des erregbaren Halbleiter-Dipols (122; 202) umfaßt, welcher zum physischen Bruch der Schmelzsicherung (121) und folglich zur Aufrechterhaltung einer vorbestimmten Spannung an dem Stift (111a) des Funktionsbausteins (111) ausschließlich über den zweiten Dipol führt, wobei diese Spannung es ermöglicht, die Funktion des Funktionsbausteins (111) zu kontrollieren.

16. Verwendung einer Vorrichtung (12) zum elektrischen Isolieren nach Anspruch 14 in einem elektrischen und/oder elektronischen integrierten System, das sich in beträchtlichen elektromagnetischen Feldern und/oder Ultraviolettstrahlungen verändert, die sich in einer Umgebung befinden, die zu der Gruppe gehört, die folgendes umfaßt:
- die industriellen Umgebungen,
- die nuklearen Umgebungen,
- die Weltraumumgebungen.
